# EUROPÄISCHE PATENTANMELDUNG

(11) **EP 2 282 388 A1**
(43) Veröffentlichungstag der Anmeldung: **09.02.2011**
(21) Anmeldenummer: 09167414.3
(22) Anmeldetag: 06.08.2009
(51) Int. Cl.: H02J 1/10, H02N 6/00, H02H 3/16

(54) **Vorrichtung zur Einspeisung elektrischer Energie von einer Vielzahl von Strings von Photovoltaikmodulen in ein Stromnetz**

(71) Anmelder: SMA Solar Technology AG, 34266 Niestetal (DE)
(72) Erfinder: Falk, Andreas, 34131 Kassel (DE); Goldau, Jan, 34260 Kaufungen (DE); Schulze, Gerold, 34125 Kassel (DE); Fischer, Jochen, 34255 Baunatal (DE)
(74) Vertreter: Rehberg Hüppe + Partner

(57) **Zusammenfassung**

Eine Vorrichtung (1) zur Einspeisung von elektrischer Energie von einer Vielzahl von Strings (2) von Photovoltaikmodulen (3) in ein Stromnetz (4) weist einen Anschluss (7) für jeden String (2), in dem Mittel zur Überstromsicherung und zum selektiven Abschalten des Strings (2) vorgesehen sind, und eine zentrale Einrichtung (15) zur Erfassung des Isolationszustands der Vielzahl von Strings (2) auf. Dabei weisen die Mittel zur Überstromsicherung und zum selektiven Abschalten des Strings (2) einen Leistungsschalter (9) auf, der motorisch öffenbar und schließbar ist.

## Beschreibung

### TECHNISCHES GEBIET DER ERFINDUNG

Die Erfindung bezieht sich auf eine Vorrichtung zur Einspeisung von elektrischer Energie von einer Vielzahl von Strings von Photovoltaikmodulen in ein Stromnetz mit den Merkmalen des unabhängigen Patentanspruchs 1.

Die einzelnen Strings, die an eine solche Vorrichtung angeschlossen werden, bestehen üblicherweise nicht nur aus einer Reihenschaltung von Photovoltaikmodulen, wie dies der ursprünglich englischsprachige Begriff String nahelegt, sondern sie weisen regelmäßig mehrere Teilstrings auf, die im Feld, d. h. am oder nahe des Ortes der Photovoltaikmodule in einer Parallelschaltung zusammengefasst sind.

Alle Teile einer Vorrichtung, auf die sich die vorliegende Erfindung bezieht, sind örtlich zusammengefasst, d. h. gegenüber der Vielzahl von Strings zentralisiert. Üblicherweise befinden sich alle Teile der Vorrichtung in einem einzelnen zentralen Gehäuse. Dies ist aber nicht zwingend der Fall. Die Vorrichtung kann vielmehr auch aus einzelnen Modulen bestehen, für die einzelne Gehäuse vorgesehen sind. Auch diese einzelnen Gehäuse befinden sich bei der Vorrichtung aber an einem Ort und sind nicht zur Anordnung im Feld bei den Photovoltaikmodulen vorgesehen.

Üblicherweise dient eine Vorrichtung, auf die sich die vorliegende Erfindung bezieht, zur Einspeisung von elektrischer Energie in ein Wechselstromnetz und weist hierzu einen Wechselrichter auf. Dieser Wechselrichter kann in nahezu beliebiger Weise mit Hochsetzstellern, Tiefsetzstellern, Umrichtern (DC/DC-Wandlern und/oder AC/AC-Wandlern) und Transformatoren kombiniert sein, um die Ausgangsspannung des Wechselrichters an die Netzspannung des Wechselstromnetzes anzupassen.

Die vorliegende Erfindung befasst sich mit der Absicherung der einzelnen Strings und der Vorrichtung zur Einspeisung von elektrischer Energie gegenüber Fehlern, insbesondere Isolationsfehlern, im Bereich der Strings und deren Zuleitungen zu der Vorrichtung.

### STAND DER TECHNIK

Bei einem aktuellen Produkt der Anmelderin, das zur Einspeisung von elektrischer Energie von einer Vielzahl von Strings von Photovoltaikmodulen in ein Stromnetz vorgesehen ist, sind in der Vorrichtung für jeden von mehreren anschließbaren Strings Schmelzsicherungen als Überstromsicherungen vorgesehen. Weiterhin ist ein zentraler Gleichstromlasttrennschalter für den von allen Strings fließenden Strom vorgesehen. Die Überwachung der einzelnen Teilstrings auf Ausfall erfolgt durch dezentrale Überwachungseinrichtungen im Feld. Von diesen müssen Signalübertragungswege zu der zentralen Vorrichtung, i. d. R. durch Signalübertragungsleitungen, bereitgestellt werden. Falls eine zentrale Einrichtung zur Erfassung des Isolationszustands der Vielzahl von Strings einen Isolationsfehler feststellt, kann nur die gesamte Vorrichtung angehalten und/oder zentrale Gleichstromlasttrennschalter geöffnet werden. Falls ein String mit falscher Polung an die bekannte Vorrichtung angeschlossen wird, brennt die zugehörige Schmelzsicherung ab, da die über ihr abfallende doppelte Leerlaufspannung von der Schmelzsicherung bei normaler Auslegung nicht geschaltet werden kann.

Eine Vorrichtung mit den Merkmalen des Oberbegriffs des unabhängigen Patentanspruchs 1 ist in Form eines Produkts der Firma Siemens bekannt. Konkret handelt es sich um einen 500 kW Wechselrichter, an den über separate Sicherungslasttrenner und Gleichstromschütze vier Strings mit einer Leistung von jeweils 125 kW angeschlossen sind und so gezielt an- und abgeschaltet werden können. Als zentrale Einrichtung zur Erfassung des Isolationszustands ist ein GFDI vorgesehen. Dieser fällt bei einem Erdschluss z. B. irgendwo im Feld der Photovoltaikmodule. Die bekannte Vorrichtung wird daraufhin in einen isolierten Betrieb überführt, um hohe Erdströme zu vermeiden. In der nächsten Nacht erfolgt eine automatische Isolationsmessung im Feld der Photovoltaikmodule. Sobald der Fehler festgestellt und einem einzelnen String zugeordnet ist, fährt die Vorrichtung am nächsten Tag wieder im geerdeten Betrieb, wobei der Gleichstromschütz zu dem von dem Erdungsfehler betroffenen String geöffnet bleibt.

### AUFGABE DER ERFINDUNG

Der Erfindung liegt die Aufgabe zugrunde, eine Vorrichtung mit den Merkmalen des Oberbegriffs des unabhängigen Patentanspruchs 1 aufzuzeigen, die eine Ertragsoptimierung hinsichtlich des in das Stromnetz eingespeisten Stroms bei gleichzeitig hoher Betriebssicherheit und günstigen Kosten des Gesamtaufbaus einer Photovoltaikanlage unter Verwendung der Vorrichtung ermöglicht.

### LÖSUNG

Erfindungsgemäß wird die Aufgabe durch eine Vorrichtung mit den Merkmalen des Patentanspruchs 1 gelöst. Bevorzugte Ausführungsformen der neuen Vorrichtung sind in den abhängigen Patentansprüchen definiert.

### BESCHREIBUNG DER ERFINDUNG

Bei der neuen Vorrichtung weisen die Mittel zur Überstromsicherung und zum selektiven Abschalten des Strings, die in jedem Anschluss für jeden String vorgesehen sind, einen Leistungsschalter auf, der motorisch öffenbar und schließbar ist. Mit diesem Leistungsschalter ist der jeweilige String abgesichert und er kann selektiv zu- und abgeschaltet werden, falls es Hinweise auf einen Fehler im Bereich seiner Teilstrings oder Zuleitungen zu der Vorrichtung gibt. Bei diesen Fehlern kann es sich insbesondere um solche handeln, die von der zentralen Einrichtung zur Erfassung des Isolationszustands der Vielzahl von Strings registriert werden. Es kann sich aber auch um Fehler handeln, die auf andere Weise erkannt werden. Vorzugsweise erfolgt diese Erkennung bei der neuen Vorrichtung aber ausschließlich innerhalb der Vorrichtung. Das heißt, es werden keine Fehler im Feld erkannt und an die Vorrichtung kommuniziert, sondern die Fehlererkennung erfolgt in der Vorrichtung, so dass es keiner Kommunikation dieser Fehler von außen in die Vorrichtung bedarf. Die Ausbildung der Mittel zur Überstromsicherung und zum selektiven Abschalten jedes Strings im Wesentlichen aus einem Leistungsschalter, der bei geringen Kosten nur eine begrenzte Stromtragfähigkeit aufweist, kann es nötig machen, den Strom und damit die Leistung auf eine vergleichsweise große Anzahl von Strings aufzuteilen, so dass jeder String nur den Strom liefert, der von einem Leistungsschalter getragen werden kann. Dies bedeutet zugleich, dass die Anzahl der Zuleitungen aus dem Feld entsprechend der Anzahl der Strings relativ groß sein kann. Die hiermit verbundenen Nachteile werden aber durch Vorteile der neuen Vorrichtung mehr als aufgewogen. Durch die größere Anzahl der Strings wirkt sich das Abschalten eines Strings über den zugehörigen Leistungsschalter beim Auftreten eines Fehlers in seinem Bereich auf die Gesamtleistung der jeweiligen Photovoltaikanlage relativ wenig aus. Die Zuleitungen von den einzelnen Strings zu der neuen Vorrichtung müssen, da sie jeweils nur einen relativ kleinen Strom führen sollen, keine großen Leitungsquerschnitte aufweisen und können von daher kostengünstig ausgebildet sein und auch einfach verlegt werden. Zudem werden bei der Verwendung der neuen Vorrichtung Kommunikationsleitungen eingespart, die üblicherweise parallel zu den stromführenden Anschlussleitungen vorhanden sind.

Konkret kann eine Steuerung der neuen Vorrichtung die Leistungsschalter in den Anschlüssen der Vielzahl der Strings abhängig von der Einrichtung zur Erfassung des Isolationszustands erfassten Isolationszustand motorisch ansteuern. Dabei erfolgt erfindungsgemäß eine Reaktion auf einen auftretenden Isolationsfehler sofort, d. h. noch am selben Tag im Betrieb der Photovoltaikmodule, mit dem Ziel, den String zu selektieren, der den Isolationsfehler verursacht, und diesen String abzuschalten, indem der zugehörige Leistungsschalter motorisch geöffnet wird.

Zu dem genannten Zweck kann die Steuerung beim Auftreten eines Isolationsfehlers zunächst alle Leistungsschalter motorisch öffnen und dann selektiv wieder schließen, um den Isolationsfehler, von dem die zentrale Einrichtung nur seine Existenz erkennen kann, einem einzelnen String zuzuordnen. Dabei kann das Wiederschließen der Leistungsschalter einzeln oder auch nach bekannten schnellen Selektionsverfahren in variablen Gruppen erfolgen.

Je nach Aufbau der zentralen Einrichtung zur Erfassung des Isolationszustands, z. B. als GFDI, Soft Grounding-Einrichtung oder als Gerät zur Erdschlussüberwachung mittels Messung des Isolationswiderstands, kann es erforderlich sein, dass die Steuerung der neuen Vorrichtung diese Einrichtung vor dem motorischen Wiederschließen aller Leistungsschalter zurücksetzt, um sie in die Lage zu versetzen, einen neuerlichen Isolationsfehler zu erkennen. Dasselbe gilt bei diesen Einrichtungen zur Erfassung des Isolationszustands, wenn ein Isolationsfehler im Folgenden einer Gruppe von Strings zugeordnet wurde, weil er beim Schließen der entsprechenden Leistungsschalter wieder aufgetreten ist und eine weitere Selektion des fehlerbehafteten Strings erfolgen soll.

Besonders bevorzugt ist es bei der neuen Vorrichtung, wenn die Mittel zur Überstromsicherung und zum selektiven Abschalten jedes Strings neben dem Leistungsschalter aus einem Stromsensor aufgebaut sind. Diese Stromsensoren ermöglichen es durch Überwachung der von den einzelnen Strings in die Vorrichtung fließenden Ströme, insbesondere bei Betrachtung des Kollektivs dieser Ströme, den Ausfall eines Teilstrings eines der Strings zu erkennen, auch wenn dieser String eine vergleichweise große Anzahl von parallel geschalteten Teilstrings aufweist. Eine derartige Überwachung kann beispielsweise darauf basieren, wie sich der Strom von dem jeweiligen String im Vergleich zu den Strömen von den anderen Strings verhält. Die Voraussetzungen für die Durchführung eines solchen Verfahrens sind bei der neuen Vorrichtung besonders gut, weil hier mit der großen Anzahl der Strings eine große Anzahl an Vergleichswerten zur Verfügung steht und damit statistische Fehler besonders gut eliminiert werden können.

Zusätzlich kann dadurch, dass jeder Stromsensor bei der neuen Vorrichtung richtungssensitiv ist, auch der Fall eines Rückstroms festgestellt werden, der auf einen Fehler im Bereich des hier angeschlossenen Strings oder der Verpolung seines Anschlusses an die neue Vorrichtung hinweist. Während ein Verpolungsfehler schnell zu einem so großen Strom führt, dass der Leistungsschalter aufgrund seiner integrierten Schutzfunktion öffnet, werden andere Fehler, die zu kleineren Rückströmen führen, nur durch den Stromsensor erkannt.

Um einen Verpolungsfehler sicher abzufangen, sind bei der neuen Vorrichtung die Leistungsschalter zumindest für die doppelte Leerlaufspannung der Strings ausgelegt. Dies ist vergleichsweise einfach zu realisieren und beseitigt jede Abbrandgefahr im Zusammenhang mit Verpolungsfehlern.

Weiter ist es bei der neuen Vorrichtung bevorzugt, dass jeder Leistungsschalter den zugehörigen String allpolig abschaltet, d. h. vollständig abtrennt, wenn der Leistungsschalter geöffnet wird. Dies ist erforderlich, um einen in einem String vorhandenen Isolationsfehler für die restliche Photovoltaikanlage zuverlässig auszuschalten.

Wie bereits angedeutet wurde, ist bei der neuen Vorrichtung für jeden String vorzugsweise nur der Anschluss für seine Leistungsstrom führenden Anschlussleitungen vorgesehen, d. h. kein zusätzlicher Anschluss zu irgendwelchen Kommunikationsleitungen. Es gibt auch keine drahtlose Signalübertragung parallel zu den den Leistungsstrom führenden Anschlussleitungen.

Die Anzahl der Anschlüsse der neuen Vorrichtung beträgt typischerweise mindestens 5, vorzugsweise mindestens 10, mehr bevorzugt mindestens 20 und am meisten bevorzugt mindestens 30. Die neue Vorrichtung ist daher für eine relativ große Anzahl von einzelnen Strings vorgesehen, die parallel zueinander an die Vorrichtung angeschlossen werden.

Besonders geeignet ist die neue Vorrichtung zur Verwendung mit Strings, von denen jeder einzelne String mindestens 10, vorzugsweise mindestens 20, mehr bevorzugt mindestens 40 und am meisten bevorzugt mindestens 50 Teilstrings aufweist. Dies sind vergleichsweise hohe Anzahlen von Teilstrings, wenn man berücksichtigt, dass diese nicht einzeln im Feld überwacht werden. Vielmehr sind bei der Verwendung der neuen Vorrichtung vorzugsweise alle Teilstrings eines Strings im Feld einfach zusammengeschlossen, wobei hier jedoch jeder Teilstring normalerweise durch eine Überstromsicherung abgesichert sein wird.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

### KURZBESCHREIBUNG DER FIGUREN

Die Erfindung wird im Folgenden anhand eines Ausführungsbeispiels unter Bezugnahe auf die beigefügten Zeichnungen näher erläutert und beschrieben.
- **Fig. 1**: zeigt die neue Vorrichtung in einem schematischen Einlinienschaubild und
- **Fig. 2**: skizziert detaillierter den Aufbau eines Anschlusses der Vorrichtung 1 für einen String.

### FIGURENBESCHREIBUNG

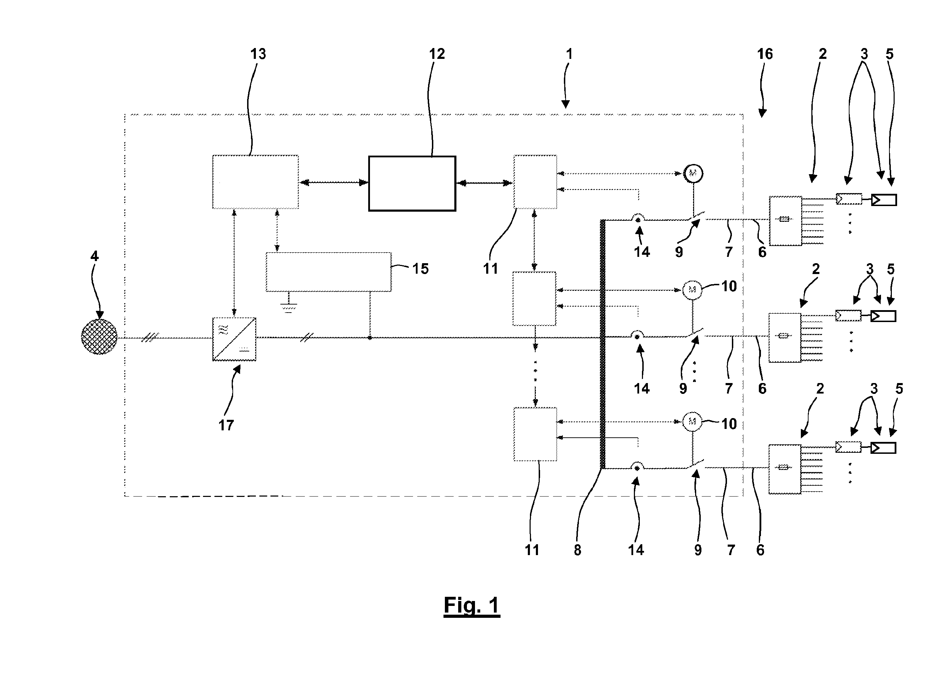

**Fig. 1** skizziert eine Vorrichtung 1 zur Einspeisung von elektrischer Energie von einer Vielzahl von Strings 2 von Solarmodulen 3 in ein Stromnetz 4, das hier ein Wechselstromnetz ist. Die durch eine gestrichelte Linie in Fig. 1 begrenzte Vorrichtung kann in einem einzigen Gehäuse untergebracht sein. In jedem Fall sind die von der gestrichelten Linie umfassten Bestandteile der Vorrichtung 1 an einem zentralen Ort und nicht dezentral verteilt im Feld bei den Photovoltaikmodulen 3 vorgesehen. Jeder String 2 umfasst nicht nur eine Reihenschaltung von Photovoltaikmodulen 3, sondern mehrere solche Teilstrings 5, die jeweils im Feld unter Absicherung der einzelnen Teilstrings 5 zusammengefasst sind, so dass aus dem Feld nur stromführende Anschlussleitungen 6 von jedem String 2 zu der Vorrichtung 1 führen. Dabei ist an der Vorrichtung 1 für jeden String 2 ein Anschluss 7 vorgesehen, an den nur ein String 2 angeschlossen wird, bevor die Ströme von allen Strings 2 auf einer gemeinsamen Busleitung 8 zusammengeführt werden. In jedem Anschluss 7 ist ein Leistungsschalter 9 vorgesehen, der mit einem Motor 10 öffenbar und schließbar ist. Hierzu wird der Motor 10 von einem Modul 11 einer Steuerung der Vorrichtung 1 angesteuert, das dem jeweiligen Anschluss 7 zugeordnet ist. Nicht dargestellt in Fig. 1 ist, dass jeder Leistungsschalter 9 einen integrierten Mechanismus aufweist, der den Leistungsschalter 9 im Falle eines einen vorgegebenen Grenzwert überschreitenden Überstroms automatisch öffnet. Zusätzlich ist in jedem Anschluss 7 ein richtungssensitiver Stromsensor 14 vorgesehen. Wenn mit diesem ein Rückstrom zu dem jeweiligen String 2 registriert wird, öffnet das zugehörige Modul 11 der Steuerung den Leistungsschalter 9 über den Motor 10, auch wenn die interne Überstromsicherung des Leistungsschalters 9 noch nicht anspricht. Überdies dienen die Stromsensoren 14 in ihrer Summe zur Überwachung der Strings 2 auf einen Ausfall einzelner Teilstrings 5, wozu das Kollektiv der von den Strings 2 fließenden und mit den Stromsensoren 14 gemessenen Ströme beobachtet und analysiert wird. Dies erfolgt in einem zentralen Modul 12 der Steuerung der Vorrichtung 1. Weiter weist die Vorrichtung 1 eine Einrichtung 15 zur Erfassung des Isolationszustands der in Fig. 1 gezeigten Photovoltaikanlage 16 einschließlich der Strings 2 auf. Bei dieser Einrichtung 15 kann es sich um einen GFDI, eine sogenannte Softgrounding-Einrichtung oder auch ein Gerät zur Erdschlussüberwachung mittels Messung des Isolationswiderstands handeln. Wird von der Einrichtung 15 ein Isolationsfehler registriert, wird dieser einem Modul 13 der Steuerung der Vorrichtung 1 mitgeteilt. Dieses Modul 13 kann daraufhin einen zentralen Wechselrichter 17 der Vorrichtung 1 anhalten oder zumindest Einfluss auf seine Betriebsweise nehmen, bis der Isolationsfehler lokalisiert ist. Falls der Isolationsfehler im Bereich eines der Strings 2 liegt, kann er dadurch erkannt werden, dass die Steuerung 11 bis 13 zunächst alle Leistungsschalter 9 öffnet. Danach darf die Einrichtung 15, die im Falle eines GFDI oder einer Soft Grounding-Einrichtung, ggf. zurückgesetzt werden muss, den Isolationsfehler nicht mehr anzeigen. Ansonsten liegt er nicht im Bereich der Strings 2, sondern an anderer Stelle vor. Wenn der Isolationsfehler nicht mehr angezeigt wird, kann durch selektives Schließen der Leistungsschalter 9 einzeln oder in Gruppen der Isolationsfehler letztlich einem einzelnen String 2 zugeordnet werden. Dieser String 2 kann dann durch Öffnen des zugehörigen Leistungsschalters 9 ausgruppiert, d. h. abgeschaltet werden und mit den restlichen Strings 2 kann weiter elektrische Energie ohne irgendwelche Beeinträchtigungen in das Netz 4 eingespeist werden. Dabei wird diese Selektion des fehlerbehafteten Strings 2 von der Steuerung 11 bis 13 im Betrieb der Photovoltaikanlage 16, d. h. während Spannung von den Strings 2 an der Vorrichtung 1 anliegt, durchgeführt. Die Vorrichtung 1 kann daher binnen sehr kurzer Zeit in einen ordnungsgemäßen Betrieb unter Einspeisung von elektrischer Energie in das Netz 4 zurückkehren. Die durch den ausgefallenen String 2 verursachten Verluste bleiben insbesondere dann gering, wenn eine vergleichsweise große Anzahl von Strings 2 parallel über jeweils einen Leistungsschalter 9 an die Vorrichtung 1 angeschlossen ist.

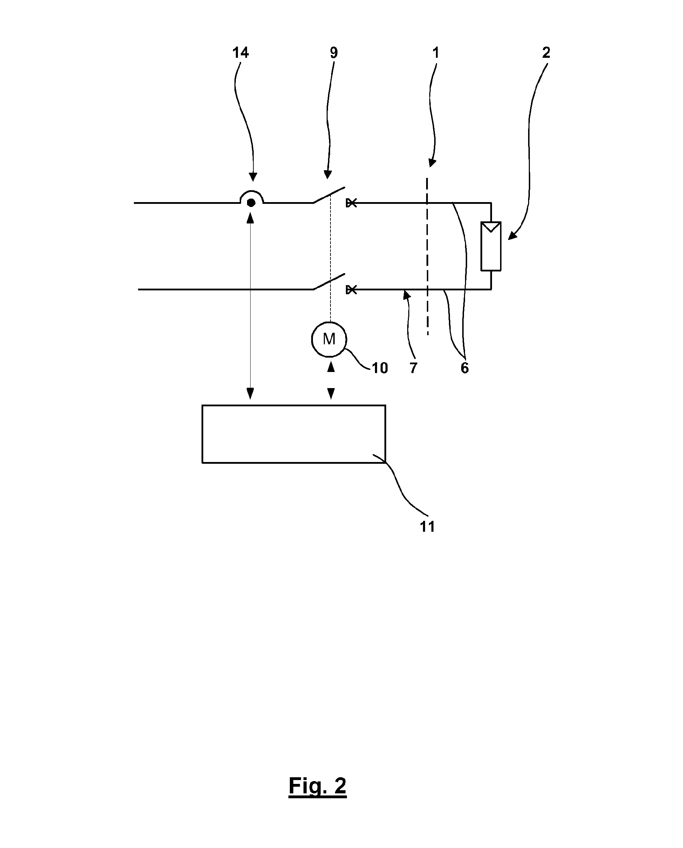

**Fig. 2** skizziert den Aufbau eines Anschlusses 7 der Vorrichtung 1 gemäß Fig. 1 in einem Zweilinienschaubild, aus dem deutlich wird, dass der Leistungsschalter 9 den hier nur schematisch wiedergegebenen angeschlossenen String 2 allpolig abtrennt. Dabei ist der Leistungsschalter 9 für die doppelte Leerlaufspannung des Strings 2 ausgelegt, so dass er auch in der Lage ist, einen mit falscher Polung an die Vorrichtung 1 angeschlossenen String 2 abzuschalten, wobei die doppelte Leerlaufspannung über den Kontakten des Leistungsschalters 9 anliegt.

### BEZUGSZEICHENLISTE

- 1: Vorrichtung
- 2: String
- 3: Photovoltaikmodul
- 4: Stromnetz
- 5: Teilstring
- 6: Anschlussleitung
- 7: Anschluss
- 8: Busleitung
- 9: Leistungsschalter
- 10: Motor
- 11: Modul der Steuerung
- 12: Modul der Steuerung
- 13: Modul der Steuerung
- 14: Stromsensor
- 15: Einrichtung zur Erfassung des Isolationszustands
- 16: Photovoltaikanlage
- 17: Wechselrichter

## Patentansprüche

1. Vorrichtung (1) zur Einspeisung von elektrischer Energie von einer Vielzahl von Strings (2) von Photovoltaikmodulen (3) in ein Stromnetz (4), mit einem Anschluss (7) für jeden String (2), in dem Mittel zur Überstromsicherung und zum selektiven Abschalten des Strings (2) vorgesehen sind, und mit einer zentralen Einrichtung (15) zur Erfassung des Isolationszustands der Vielzahl von Strings (2), **dadurch gekennzeichnet, dass** die Mittel zur Überstromsicherung und zum selektiven Abschalten des Strings (2) einen Leistungsschalter (9) aufweisen, der motorisch öffenbar und schließbar ist.

2. Vorrichtung (1) nach Anspruch 1, **dadurch gekennzeichnet, dass** eine Steuerung (11-13) die Leistungsschalter (9) in den Anschlüssen (7) der Vielzahl der Strings (2) abhängig von dem erfassten Isolationszustand motorisch ansteuert.

3. Vorrichtung (1) nach Anspruch 2, **dadurch gekennzeichnet, dass** die Steuerung (11-13) im Betrieb der Photovoltaikmodule (3) den String (2) selektiert, der einen Isolationsfehler aufweist, und den zugehörigen Leistungsschalter (9) motorisch öffnet.

4. Vorrichtung (1) nach Anspruch 2 oder 3, **dadurch gekennzeichnet, dass** die Steuerung (11-13) beim Auftreten eines Isolationsfehlers zunächst alle Leistungsschalter (9) motorisch öffnet und dann selektiv wieder schließt.

5. Vorrichtung (1) nach Anspruch 4, **dadurch gekennzeichnet, dass** die Steuerung (11-13) die Leistungsschalter (9) einzeln und/oder in Gruppen wieder schließt.

6. Vorrichtung (1) nach mindestens einem der vorhergehenden Ansprüche, **dadurch gekennzeichnet, dass** die Mittel zur Überstromsicherung und zum selektiven Abschalten des Strings (2) aus dem Leistungsschalter (9) und einem Stromsensor (14) aufgebaut sind.

7. Vorrichtung (1) nach Anspruch 6, **dadurch gekennzeichnet, dass** eine Überwachungseinrichtung den von dem Stromsensor (14) gemessenen Strom auf den Ausfall eines Teilstrings (5) des zugehörigen Strings (2) überwacht.

8. Vorrichtung (1) nach Anspruch 6 oder 7, **dadurch gekennzeichnet, dass** der Stromsensor (14) richtungssensitiv ist.

9. Vorrichtung (1) nach Anspruch 8, **dadurch gekennzeichnet, dass** eine Steuerung (11-13) den Leistungsschalter (9) motorisch öffnet, wenn der Stromsensor (14) einen Rückstrom registriert.

10. Vorrichtung (1) nach mindestens einem der vorhergehenden Ansprüche, **dadurch gekennzeichnet, dass** jeder Leistungsschalter (9) für die doppelte Leerlaufspannung der Strings (2) ausgelegt ist.

11. Vorrichtung (1) nach mindestens einem der vorhergehenden Ansprüche, **dadurch gekennzeichnet, dass** jeder Leistungsschalter (9) den zugehörigen String (2) allpolig abschaltet.

12. Vorrichtung (1) nach mindestens einem der vorhergehenden Ansprüche, **dadurch gekennzeichnet, dass** für jeden String (2) nur der Anschluss (7) für seine Leistungsstrom führenden Anschlussleitungen (6) vorgesehen ist.

13. Vorrichtung (1) nach mindestens einem der vorhergehenden Ansprüche, **dadurch gekennzeichnet, dass** Anschlüsse (7) für mindestens 5, vorzugsweise mindestens 10, mehr bevorzugt mindestens 20 und am meisten bevorzugt mindestens 30 Strings (2) vorgesehen sind.

14. Verwendung einer Vorrichtung (1) nach mindestens einem der vorhergehenden Ansprüche, wobei jeder String (2) mindestens 10, vorzugsweise mindestens 20, mehr bevorzugt mindestens 40 und am meisten bevorzugt mindestens 50 Teilstrings (5) aufweist.

15. Verwendung nach Anspruch 14, **dadurch gekennzeichnet, dass** alle Teilsstrings (5) eines Strings (2) im Feld zusammengeschlossen sind, wobei jeder Teilstring (5) durch eine Überstromsicherung abgesichert ist.
